# EUROPEAN PATENT SPECIFICATION

(11) **EP 4 160 704 B1**
(45) Date of publication and mention of the grant of the patent: **18.12.2024**
(21) Application number: 22198070.9
(22) Date of filing: 27.09.2022
(51) Int. Cl.: H01L 33/60

(54) **LIGHT EMITTING DEVICE AND METHOD OF MANUFACTURING LIGHT EMITTING DEVICE**
LICHTEMITTIERENDE VORRICHTUNG UND VERFAHREN ZUR HERSTELLUNG DER LICHTEMITTIERENDEN VORRICHTUNG
DISPOSITIF ÉLECTROLUMINESCENT ET PROCÉDÉ DE FABRICATION DE DISPOSITIF ÉLECTROLUMINESCENT

(30) Priority: 29.09.2021 JP 2021159175; 26.08.2022 JP 2022134625
(43) Date of publication of application: 05.04.2023
(73) Proprietor: Nichia Corporation, Anan-shi, Tokushima 774-8601 (JP)
(72) Inventor: KUSUSE, Takeshi, Tokushima, 774-8601 (JP); TAMURA, Kazuya, Tokushima, 774-8601 (JP); KISHIKAWA, Daisuke, Tokushima, 774-8601 (JP); YAMANOI, Takuya, Tokushima, 774-8601 (JP); TADA, Takaaki, Tokushima, 774-8601 (JP); OZEKI, Kenji, Tokushima, 774-8601 (JP)
(74) Representative: Betten & Resch

(56) References cited:
- EP-A1- 1 873 563
- WO-A1-2022/071230
- JP-A- 2011 249 768
- JP-A- 2012 149 110
- JP-A- 2012 256 651
- US-A1- 2011 204 406
- US-A1- 2014 153 262

## Description

### BACKGROUND

The present invention relates to a light emitting device and a method of manufacturing the light emitting device.

Some light emitting devices such as LEDs include a light emitting element and a light reflecting member that reflects the light from the light emitting element. For example, Japanese Patent Publication No. 2014-216416 discloses, as a light reflecting member, reflecting material that contains a white pigment, such as titania, zinc oxide, tantalum oxide, niobium oxide, zirconia, alumina, or the like, in a base material which is a heat-resistant resin such as silicone or an inorganic binder.

WO 2022/071230 A1 discloses a light-emitting device that comprises a light-emitting element and a light-reflecting covering member which covers the light-emitting element and which includes plate-form light reflective material, silica, and an alkali metal. A method of producing this light-emitting device is also provided.

US 2014/153262 A1 discloses providing a glass ceramic body, whereby light which transmits through the substrate and leaks (i.e. emits) out of the incident direction is reduced, and the number of voids at the surface of the substrate and in the inside of the substrate is low.

### SUMMARY

The Present invention is defined by the independent claims. Dependent claims specify embodiments thereof.

The recent advancements in achieving a higher luminance and higher output light emitting device have brought about a large increase in the temperature of the light reflecting member during the operation of the device. There is thus a need for a high heat resistance light reflecting member.

One obj ect of the present invention is to provide a light emitting device equipped with a high heat resistance light reflecting member, and a method of manufacturing such a light emitting device.

According to certain exemplary embodiments of the present invention, a light emitting device equipped with a high heat resistance light reflecting member, and a method of manufacturing such a light emitting device can be provided.

### BRIEF DESCRIPTION OF THE DRAWINGS

FIG. 1 is an exemplary cross-sectional view enlarging a portion of a light reflecting member of a light emitting device according to Embodiment 1.
FIG. 2 is an exemplary schematic perspective view of an exemplary light reflective particle in the light reflecting member shown in FIG. 1.
FIG. 3A is an exemplary schematic cross-sectional view of the light emitting device according to an example not forming part of the present invention.
FIG. 3B is an exemplary schematic top view of the light emitting device shown in FIG. 3A.
FIG. 3C is an exemplary schematic top view of another exemplary configuration of the light emitting device shown in FIG. 3A.
FIG. 3D is an exemplary schematic cross-sectional view of the light emitting device according to an embodiment of the present invention.
FIG. 3E is an exemplary schematic cross-sectional view of another light emitting device according to an example not forming part of the present invention.
FIG. 3F is an exemplary schematic cross-sectional view of another light emitting device according to an example not forming part of the present invention.
FIG. 4A is an exemplary schematic cross-sectional view of a light emitting device according to an example not forming part of the present invention.
FIG. 4B is an exemplary schematic top view of the light emitting device shown in FIG. 4A.
FIG. 4C is an exemplary schematic cross-sectional view of another exemplary configuration of the light emitting device shown in FIG. 4A.
FIG. 5 is an exemplary schematic cross-sectional view of a light emitting device according to another example not forming part of the present invention.
FIG. 6 is an exemplary schematic cross-sectional view of a light emitting device according to another example not forming part of the present invention.

### DETAILED DESCRIPTION

In the drawings, members having the same functions may be denoted by the same reference numerals. Focusing on the main points and considering ease of understanding, constituent elements may be described in a certain embodiment or example, but may be partially substituted or combined with those described in different embodiments and examples. The explanation of the features already discussed in a previous embodiment or example may be omitted in later embodiments or examples, and only the differences from the earlier embodiment or example may be explained. Specifically, similar effects achieved by similar constituents will not be repeated for each embodiment. The sizes and the relative positions of the members in the drawings may be exaggerated for clarity of explanation. An end surface view that only shows a cut section might be used as a cross-sectional view.

### EMBODIMENT 1

A light emitting device according to Embodiment 1 includes a light emitting element and a light reflecting member that reflects the light emitted from the light emitting element. The light reflecting member contains plate-shaped light reflective particles, silica, and an alkali metal. The average particle size of the light reflective particles is in a range of 0.6 *µ*m to 43 *µ*m, and the average aspect ratio of the light reflective particles is 10 or higher.

Allowing the light reflective particles to function as an aggregate in the light reflecting member having the constituents described above can reduce the deformation of the light reflecting member 5 even if the light reflecting member temperature fluctuates. The heat resistance of such a light reflecting member can be increased. This can enhance the heat resistance and the service life of the light emitting device according to Embodiment 1. Because the light reflecting member constructed as above is composed of inorganic materials, in the case of employing an ultraviolet light emitting element, degradation attributable to ultraviolet light can be reduced.

A light reflecting member according to the present disclosure is applicable to light emitting devices of various structures. Accordingly, specific constituents of a light reflecting member itself will be described in detail with reference to Embodiment 1 below, and the forms of or the applicable locations for the light reflecting member in a light emitting device, as well as other constituents of the light emitting device (substrate, light emitting element, or the like) will be explained in detail with reference to other Embodiments and Examples discussed later.

### Light Reflecting Member

A light reflecting member 5 is a member that reflects the light emitted from a light emitting element.

The light reflecting member 5 is made up of multiple inorganic materials.

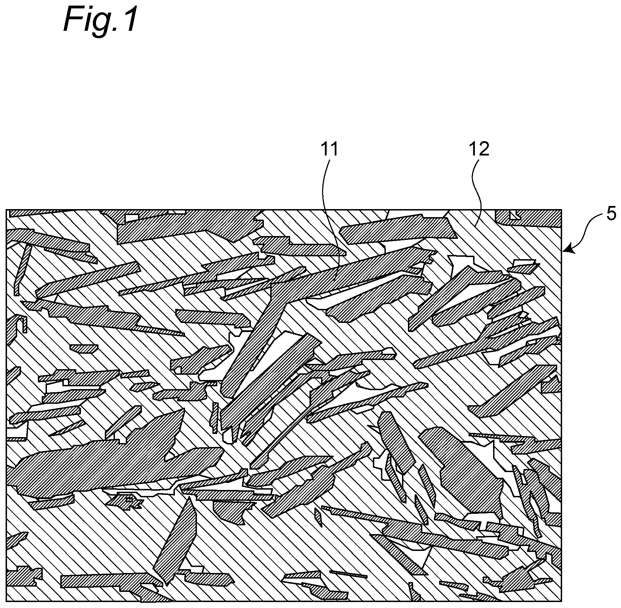

As shown in FIG. 1, the light reflecting member 5 includes light reflective particles 11 and a binder 12 that binds the light reflective particles 11. The binder 12 contains silica and an alkali metal. The light reflecting member 5, as described later, is formed through the heating step in which the mixture of the light reflective particles 11, powdered silica, and an alkaline solution is heated.

The light reflecting member 5 may be composed only of inorganic materials, or primarily of inorganic materials.

The light reflecting member 5 has protrusions and indentations on its surface. The surface roughness (Ra) attributable to protrusions and indentations is 1 to 3 microns. The surface roughness can be measured by using a laser microscope.

Also, the light reflecting member 5 may have gaps formed therein due to the evaporation of water contained in the alkaline solution. The void formed in this manner is a space including a portion that serves as a path through which water evaporates, and at least a portion of the gap includes a portion that opens to the surface of the light reflecting member. All the gaps may be one continuous space inside the light reflecting member, or may be a plurality of spaces separated inside the light reflecting member. The size and shape of the gaps are irregular. In addition, it can be said that the gaps communicating with the surface of the light reflecting member 5 are part of the irregularities on the surface of the light reflecting member 5.

### Light Reflective Particles

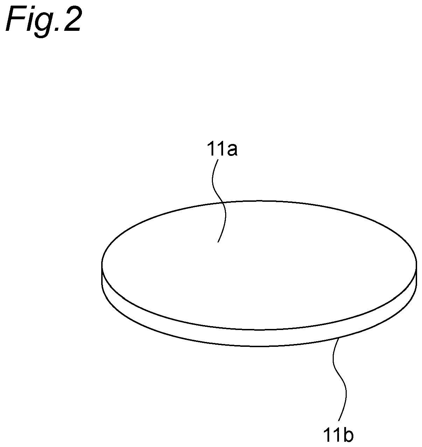

A light reflective particle 11, as an example shown in FIG. 2, is a plate-shaped particle having a principal surface 11a and another principal surface 11b located opposite to the principal surface 11a. The principal surface 11a and the other principal surface 11b can also be referred to as the upper surface and the lower surface of the light reflective particle 11. The light reflective particle 11 can also be referred to as a flaky particle. FIG. 2 is a mere schematic diagram of a light reflective particle 11 regarded, for example, as a circular plate-shaped particle in a top view to make the shape of the light reflective particle 11 more easily understood.

The light reflective particles 11, for example, comprises, consists essentially of, or consists of boron nitride or alumina. These materials would be able to reflect ultraviolet to visible light.

Light reflective particles 11 may be primary particles, secondary particles in which two or more primary particles are clumped together, or a mixture of primary particles and secondary particles.

In the light reflecting member 5 of a light emitting device, the average aspect ratio of the light reflective particles 11 is 10 or higher, preferably 10 to 70. Here, the light reflective particles 11 are slightly fusion-bonded to silica and slightly eluted by an alkaline solution in the heating process. Accordingly, the shapes of the light reflective particles 11 contained in the light reflecting member 5 formed as a result of heating practically remains the same as those prior to heating. In other words, the light reflective particles 11 contained in the heat processed light reflecting member 5, for example, is a plate-shaped particle having the one particle surface and the other principal surface.

The average aspect ratio of the light reflective particles 11 is calculated by the exemplary method described below.

### Average Aspect Ratio Calculation Method

The average aspect ratio of the light reflective particles 11 is calculated based on the measurements of the thicknesses and the widths of the light reflective particles 11 contained in the light reflecting member 5 in a cross section of the light emitting device that includes a cross section of the light reflecting member.

First, the light emitting device is cut to expose a cross section.

Subsequently, the exposed cross section is polished to a mirror finish. An image of the mirror-finish cross section is captured by using a scanning electron microscope (SEM) for extracting cross sections of light reflective particles 11, a region which contains about 1000 light reflective particle cross sections is selected for measurement purposes. The pixel count of the microscope is set to about 20 million pixels, and the magnification to 500× to 3000×. In the present disclosure, a cross section of a light reflective particle 11 refers to a surface practically perpendicular to the one principal surface and/or the other principal surface of the light reflective particle 11. Because of their shapes, the plate-shaped light reflective particles 11 tend to be arranged in the light reflecting member 5 to overlap one another, i.e., a principal surface of a particle surfaces a principal surface of another particle. Accordingly, appropriately selecting a cross section of the light emitting device to be exposed allows a SEM to extract the cross sections of the light reflective particles 11.

Subsequently, by using image analysis software, the width (the length of a cross section of a light reflective particle in the long-dimension direction) and the thickness (the length of the cross section of the light reflective particle in the transverse direction) of each light reflective particle 11 cross section are measured at a point (e.g., the maximum length in each direction), and the average value of the ratio of the width to the thickness calculated. The average value for 100 light reflective particles 11 is used as the average aspect ratio.

In the case of using boron nitride for the light reflective particles 11, the average aspect ratio of the light reflective particles 11 is, for example, 16.5 to 19.2. In the case of using alumina for the light reflective particles 11, the average aspect ratio of the light reflective particles 11 is, for example, 10 to 70.

Furthermore, the average particle size of the light reflective particles 11 is 0.6 *µ*m to 43 *µ*m.

As described above, the light reflective particles 11 are slightly fusion-bonded to silica and slightly eluted by an alkaline solution in the heating process. Accordingly, the shapes and dimensions of the light reflective particles 11 prior to the heating process are practically identical as the shapes and dimensions of the light reflective particles 11 contained in the light reflecting member 5 formed as a result of the heating process. Thus, the average particle size of the light reflective particles 11 described above is calculated by measuring the particle sizes of the light reflective particles 11 using the method described below.

### Average Particle Size Calculation Method

The particle sizes of the light reflective particles 11 are calculated by using a scanning electron microscope, e.g., "TM3030 Plus" manufactured by Hitachi High Technologies, Co., Ltd.

A surface of a double-sided carbon tape is adhered to the sample stage of the microscope, followed by placing the light reflective particles 11 on the other surface of the double-sided tape. An image containing 100 light reflective particles 11 is captured by setting the pixel count of the microscope to 1.23 million pixels, and the magnification to 1000× to 2000×. Subsequently, the particle sizes of the individual particles are measured by using image analysis software. In the present disclosure, the particle size of a light reflective particle 11 is the largest diameter of the particle when viewing the principal surface 11a or the principal surface 11b of the light reflective particle 11. Subsequently, the median diameter of the measured particles is calculated, and the calculated value is used as the average particle size. The particle sizes of the light reflective particles 11 may be calculated by extracting a cross section of the light reflecting member by using a SEM, followed by measuring the diameters using image analysis software.

In the case of using boron nitride for the light reflective particles 11, the average particle size of the light reflective particles 11 is, for example, 6 *µ*m to 43 *µ*m. In the case of using alumina for the light reflective particles 11, the average particle size of the reflective particles 11 is, for example, 0.6 *µ*m to 10 *µ*m.

The calculation methods for the average aspect ratio and the average particle size described above are in the case of calculating the values using primary particles. In the case of using secondary particles, the calculation methods can be applied to individual single particles extracted from the secondary particles.

### Silica

The content ratio of silica to the light reflective particles 11 in the light reflecting member 5 in terms of a weight ratio is, for example, 1:4 to 1:1. In other words, the weight of the light reflective particles 11 in the light reflecting member 5 is, for example, 1 to 4 times the weight of the silica in the light reflecting member 5. A ratio falling within this range can reduce the hardening shrinkage of the mixture. If the light reflective particle content is too large, inadequate hardening might result. On the other hand, if the silica content is too large, hardening shrinkage can increase to cause cracking.

The average particle size of silica is, for example, 0.1 *µ*m to 10 *µ*m. An average particle size falling within this range can increase the density of the raw materials (light reflective particles and silica) per unit volume, thereby ensuring the strength of the light reflecting member 5.

The average particle size of silica is preferably smaller than the average particle size of the light reflective particles. This allows silica to be disposed in the gaps among the light reflective particles when mixed together. The average particle size of silica can be calculated by measuring the particle distribution of silica by laser diffraction. An average particle size of silica is a value based on the measurements made prior to being mixed with an alkaline solution. This is because silica dissolves in an alkaline solution, making it difficult to measure the particle sizes using the light reflecting member 5. The content ratio of silica to light reflective particles may be calculated using the light reflecting member 5, for example, by observing a cross section of the light reflecting member 5 extracted by a SEM, and calculating the ratio based on the areas occupied by silica and the light reflective particles.

### Alkali Metal

The alkali metal contained in the light reflecting member 5 is an alkali metal contained in the alkaline solution described above. The alkali metal is, for example, potassium and/or sodium.

The light reflecting member 5 containing the light reflective particles 11 and silica described above can reflect the light emitted from a light emitting element by utilizing the refractive index difference between the light reflective particles 11 and the binder 12 that includes silica.

Furthermore, allowing the light reflective particles 11 having the average particle size and the average aspect ratio described above to function as an aggregate can reduce the deformation of the light reflecting member 5 even if the temperature of the light reflecting member 5 fluctuates. Specifically, the expansion of the light reflecting member is reduced when the temperature of the light reflecting member increases because of a light emitting element, and the contraction of the light reflecting member is reduced when the temperature decreases because of a light emitting element. Such a light reflecting member can have high heat resistance. Here, the temperature fluctuations of the light reflecting member 5 are caused primarily by the heat propagated from a light emitting element to the light reflecting member 5 and the heat generated in the light reflecting member 5 itself by the light emitted from the light emitting element.

Achieving such a light reflecting member 5 that is resistant to expansion and contraction attributable to temperature fluctuations of the light reflecting member 5 can improve the reliability of a light emitting element even under the conditions where the light emitting element generates a high amount of heat (e.g., when a large amount of electric power is supplied to the light emitting element). When a large amount of electric power can be supplied to a light emitting element, the amount of light per light emitting device can be increased.

Furthermore, the light reflecting member 5 preferably includes a scattering material. This can increase the reflectivity of the light reflecting member 5. The scattering material, for example, is primarily zirconia or titania. In the case in which the light emitting element emits ultraviolet light, zirconia which hardly absorbs light in the ultraviolet wavelength range is preferable. In the case of adding a scattering material to the light reflecting member 5, the scattering material is dispersed in silica in the binder 12.

For the scattering material, titania may be used alone, or titania may have a coating composed of one or more of silica, alumina, zirconia, zinc, and an organic material. The coating can be formed by a known technique, such as sputtering, vapor deposition, or the like.

For the scattering material, zirconia may be used alone, or zirconia may have a coating composed of one or more of silica, alumina, zinc, and an organic material. The coating can be formed by a known technique, such as sputtering, vapor deposition, and the like. Alternatively, stabilized or partially stabilized zirconia to which calcium, magnesium, yttrium, aluminum, or the like is added may be used.

The average particle size of the scattering material is preferably smaller than the average particle size of the light reflective particles 11. This facilitates the placement of the scattering material among the light reflective particles 11, thereby reducing the transmission of the light emitted from the light emitting element 4 through the gaps among the light reflective particles 11 in the light reflecting member 5. In other words, the light emitted from the light emitting element 4 is reflected by the scattering material positioned in the gaps among the light reflective particles 11. This can increase the light extraction efficiency of the light emitting device. The average particle size of the scattering material is measured by laser diffraction.

Hereinafter, specific structures of light emitting devices equipped with the light reflecting member 5 described above in different forms will be explained.

### EMBODIMENT 2

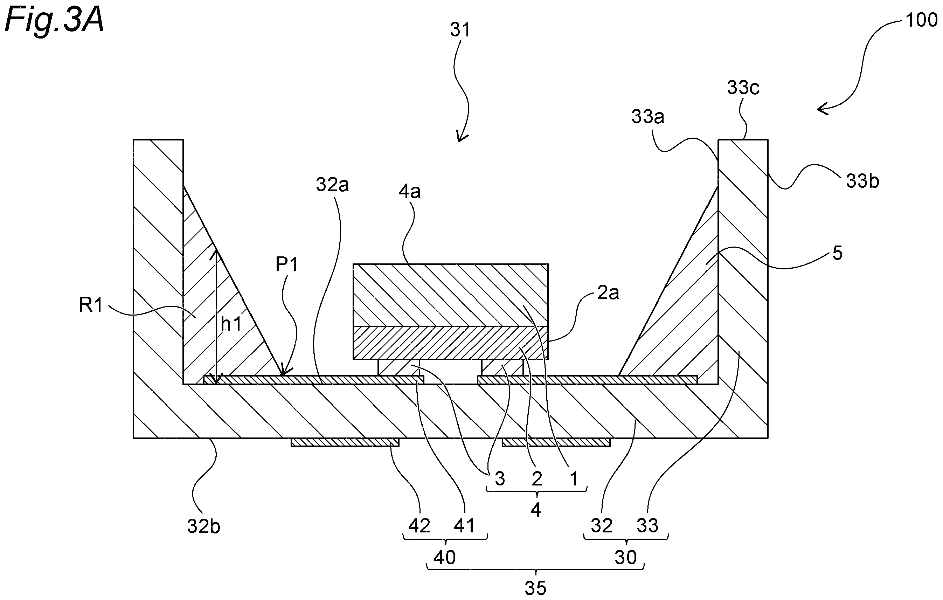

As shown in FIG. 3A to FIG. 3F, each of the light emitting devices 100, 101, 102, and 103 includes a base 35, a light emitting element 4, and a light reflecting member 5. The light emitting element 4 and the light reflecting member 5 are disposed on the base 35. The light emitting element 4 includes a semiconductor layer 2. The lateral surfaces of the semiconductor layer 2 are distanced from the light reflecting member 5 at least in part.

### Base

A base 35 has a bottom portion 32 and a wall portion 33 that define a recess 31. The recess 31 is a space surrounded by the bottom portion 32 and the wall portion 44. The bottom portion 32 and the wall portion 33 may be composed of the same material or different materials.

For the base material 30 of the base 35, an insulating material, such as glass, ceramic, resin, wood, pulp, or the like, or a conductive material, such as a semiconductor, metal (e.g., copper, silver, gold, or aluminum), or the like, by itself or as a composite material can be used. For the base material 30, in particular, a metal, ceramic, or the like is preferable, a ceramic which is an inorganic material is more preferable. Examples of ceramics include alumina, aluminum nitride, silicon nitride, mullite and the like. Particularly, aluminum nitride which has high heat dissipation performance is preferable.

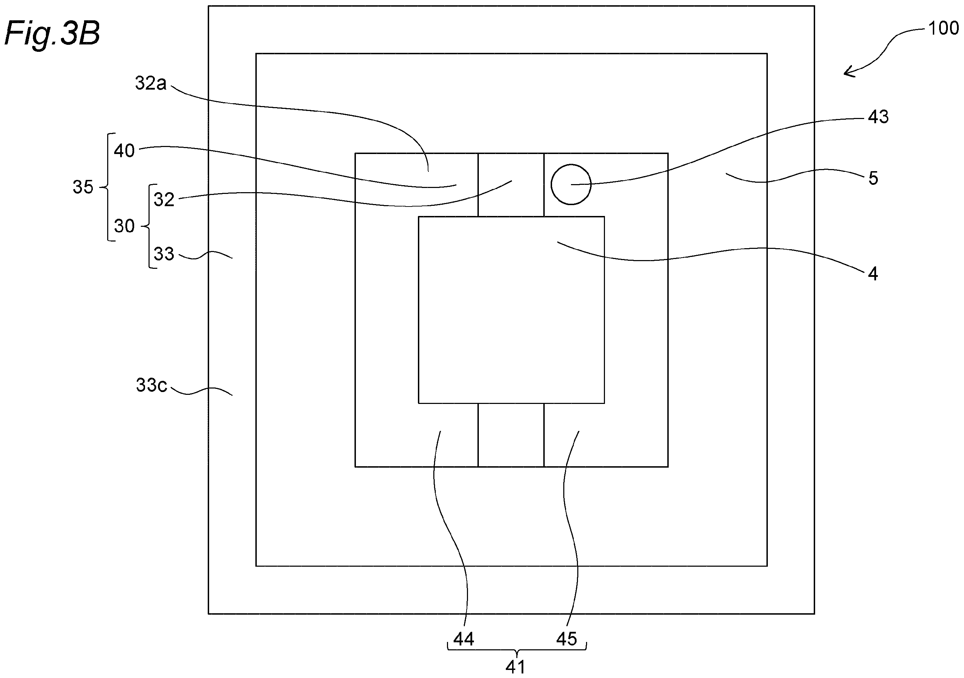

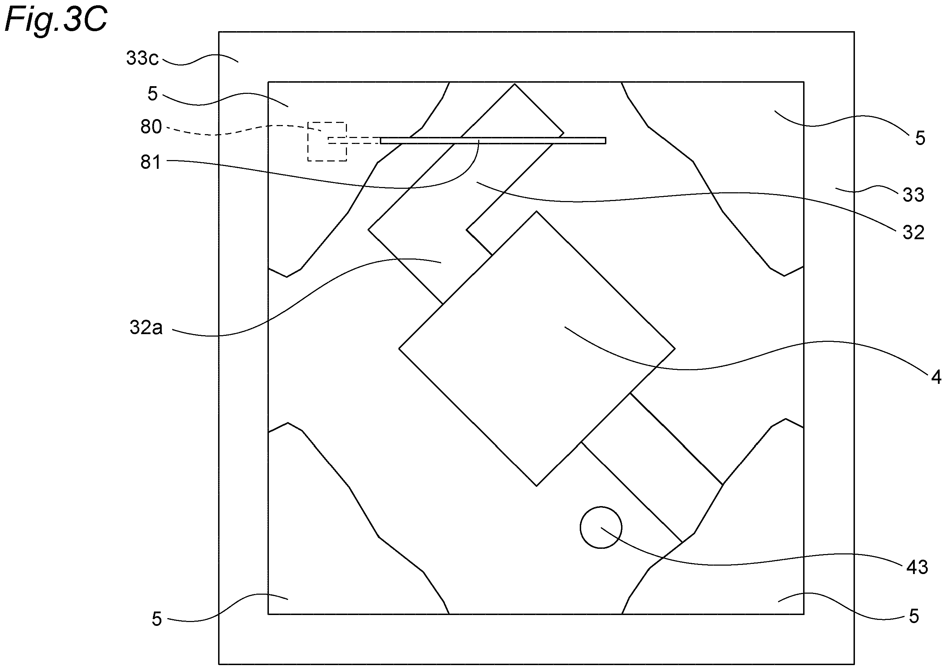

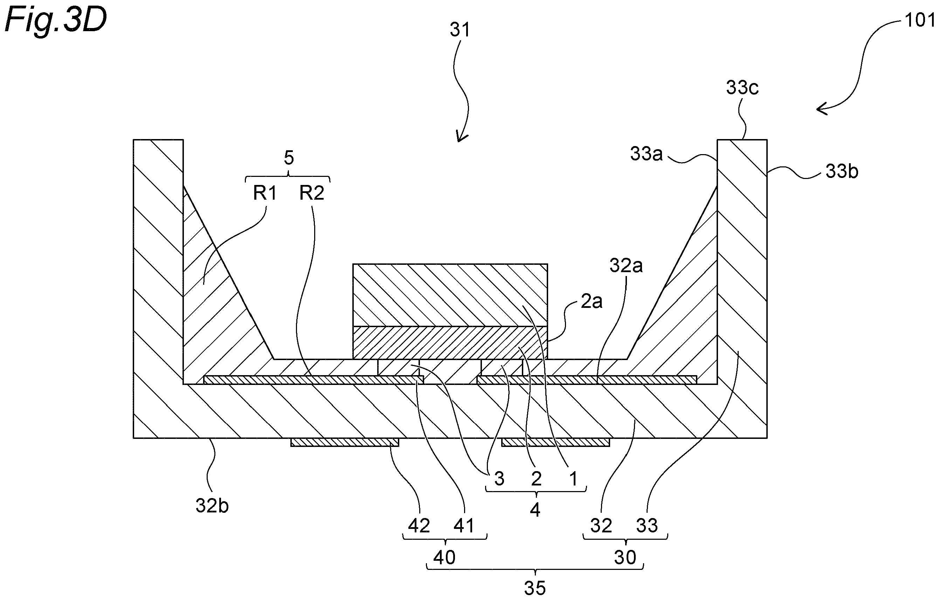

The base 35 includes conductive parts 40. The conductive parts 40, as shown in FIG. 3A and FIGS. 3D to 3F, include a wiring layer 41 and external electrodes 42. The wiring layer 41 is disposed on the upper surface 32a of the bottom portion 32, and is electrically connected to the electrodes 3 of the light emitting element 4 described later. The external electrodes 42 are disposed on the lower surface 32b of the bottom portion 32, and electrically connected to external terminals. The wiring layer 41 and the external electrodes 42 are electrically connected using vias (through holes) formed in the bottom portion 32. The wiring layer 41, as shown in FIG. 3B and FIG. 3C, includes an anode side wiring layer 44 and a cathode side wiring layer 45.

As shown in FIG. 3A and FIGS. 3D to 3F, in the cross-sectional views, the wall portion 33 of the base 35 has a constant thickness. As shown in FIG. 3B and FIG. 3C, in the top views, the shapes of the outer boundary and inner boundary of the wall portion 33 of the base 35 are quadrangular. However, the shape of the wall portion 33 is not limited to this, and may be known shapes.

### Light Emitting Element

A light emitting element 4 is disposed on the bottom portion 32 of the base 35 in the recess 31. One light emitting element 4 may be disposed on the bottom portion 32 of the base 35. Two or more light emitting elements 4 may be disposed on the bottom portion 32 of the base 35.

The light emitting element 4 includes a substrate 1 and a semiconductor layer 2. The substrate 1 is a crystal growth substrate on which a semiconductor crystal making up the semiconductor layer 2 can be grown. The substrate 1 is, for example, a sapphire substrate. The semiconductor layer 2 includes, for example, an n-type semiconductor layer, a p-type semiconductor layer, and an active layer between the n-type semiconductor layer and the p-type semiconductor layer.

The peak wavelength of the light emitted by the semiconductor layer 2 is, for example, in the 260 nm to 630 nm range. The light emitting element 4 emits, for example, ultraviolet or blue light.

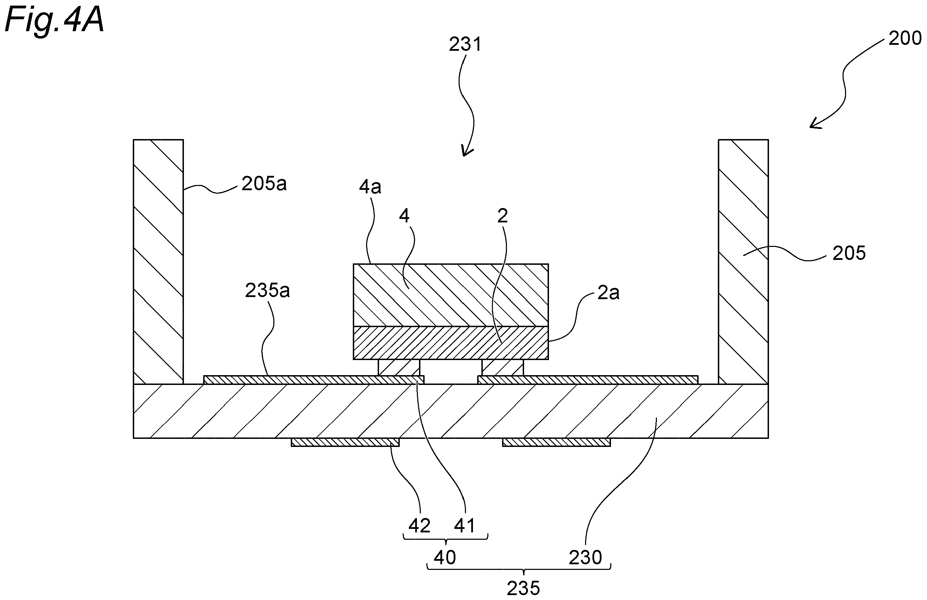

In each of the examples shown in FIG. 3A, FIGS. 3D to 3F, a pair of electrodes 3 are disposed on the lower surface of the semiconductor layer 2 and electrically connected to the wiring layer 41. The pair of electrodes 3 disposed on the lower surface of the semiconductor layer 2 are p-electrode and n-electrode. The same applies to the examples shown in FIG. 4A, FIG. 4B, FIG. 4C, FIG. 5 and FIG. 6.

The semiconductor layer 2 may have a double hetero junction structure. The emission layer may have a single quantum well structure (SQW) or a structure having multiple well layers such as a multiquantum well structure (MQW). The semiconductor layer 2 is constructed to emit visible light or ultraviolet light. The semiconductor layer 2 which includes such an active layer can include, for example, InₓAl_{y}Ga_{1-x-y}N (0≤x, 0≤y, x+y≤1).

The semiconductor layer 2 may have one or more emission layers. The structure of the semiconductor layer 2 having multiple emission layers may be one in which multiple emission layers are provided between an n-type semiconductor layer and a p-type semiconductor layer, or one in which a structure that successively includes an n-type semiconductor layer, an emission layer, and a p-type semiconductor layer is repeatedly stacked. When the semiconductor layer 2 includes multiple emission layers, it may include emission layers emitting light of different peak emission wavelengths or the same peak emission wavelength. The same peak emission wavelength may include a variation of about several nanometers. A combination of peak emission wavelengths of such emission layers can be suitably selected. For example, in the case where the semiconductor layer 2 includes two emission layers, emission layers can be selected in combinations, such as blue light and blue light, green light and green light, red light and red light, ultraviolet light and ultraviolet light, blue light and green light, blue light and red light, green light and red light, or the like. Each emission layer may include a plurality of active layers emitting light having different peak emission wavelengths or the same peak emission wavelength.

The shape of the light emitting elements 4 shown in the top views, FIG. 3B and FIG. 3C, is quadrangular. However, the top view shape of the light emitting element 4 may be known shapes.

### Light Reflecting Member

A light reflecting member 5 reflects the light emitted from the light emitting element 4 in the extraction direction. The light reflected by the light reflecting member 5 is extracted from the light emitting device 100 upwards, above the base 35.

The light reflecting member 5, in an example not forming part of the present invention as shown in FIG. 3A, is disposed on the bottom portion 32 of the base 35 along the inner lateral surfaces 33a of the wall portion 33 of the base 35.

The light reflecting member 5, in the example not forming part of the present invention shown in FIG. 3B, is continuously disposed to entirely surround the peripheral area around the light emitting element 4. In this example, in the top view, two opposing sides of the quadrangularly outlined light emitting element 4 are in parallel to two opposing sides of the quadrangularly outlined base 35. The other two opposing sides of the light emitting element 4 are in parallel to the other two opposing sides of the base 35.

The light reflecting member 5, without being limited to continuously entirely surrounding the peripheral area around the light emitting element 4, may be intermittently disposed in the peripheral area around the light emitting element 4 such that they are distanced from one another. For example, as shown in FIG. 3C, the light reflecting members 5 may be disposed at the four corners formed by the inner lateral surfaces 33a of the wall portion 33 so as to be distanced from one another. Alternatively, the light reflecting member 5 may have a first portion and a second portion, the first portion being disposed continuously across two of the four corners formed by the inner lateral surfaces 33a of the wall portion 33, and the second portion being disposed continuously across the other two corners distanced from the first portion.

In the light emitting device 100A, the example not forming part of the present invention shown in FIG. 3C, the light reflecting member 5 disposed at each corner practically has a triangular pyramid shape, in which the vertex is an upper corner of the quadrangular recess 31 and the height gradually decreases towards the bottom surface that is practically shaped as an isosceles triangle.

In the example shown in FIG. 3C, none of the four sides of the quadrangular outline of the light emitting element 4 in the top view is in parallel to any side of the quadrangular outline of the base 35. Specifically, the light emitting element 4 is disposed to surface its four lateral surfaces to the light reflecting members 5 disposed at the four corners. In other words, each lateral surface of the light emitting element 4 substantially forms a 45 degree angle with the wall portion 33 in the top view. This allows the light reflecting members 5 to more effectively reflect the light exiting the lateral surfaces of the light emitting element 4.

The example shown in FIG. 3B may also be structured such that the four sides of the quadrangular outline of the light emitting element 4 in the top view is not in parallel to any side of the quadrangular outline of the base 35.

The light reflecting member 5, as shown in FIG. 3A to FIG. 3F, includes an oblique portion R1 having oblique surfaces whose height h1 from the upper surface 32a to the bottom portion 32 decreases from the wall portion 33 towards the light emitting element 4. The oblique portion R1 is continuous with the inner lateral surfaces 33a of the wall portion 33 and the upper surface 32a of the bottom portion 32. In other words, the oblique portion R1 is provided to straddle the inner lateral surfaces 33a of the wall portion 33 and the upper surface 32a of the bottom portion 32. The end P1 of the oblique portion R1 on the light emitting element 4 side may be located anywhere between the wall portion 33 and the light emitting element 4, and may be in contact with the electrodes 3 of the light emitting element 4. When the end P1 is positioned between the wall portion 33 and the light emitting element 4, for example, the end P1 is roughly positioned at the halfway point between the wall portion 33 and the light emitting element 4 as shown in FIG. 3A. However, regardless of the position of the end P1, the light reflecting member 5 is preferably disposed at a distance from the lateral surfaces 2a of the semiconductor layer 2. This can suppress the light reflecting member 5 from blocking the light that exits the lateral surfaces 2a of the semiconductor layer 2. In other words, this makes it difficult for the light emitted from the light emitting element 4 that is reflected by the light reflecting member 5 to return to the light emitting element 4, thereby allowing the light to exit in the desired direction.

In the light emitting device 100, in the example shown in FIG. 3A, the oblique surface of the oblique portion R1 of the light reflecting member 5 that opposes a lateral surface of the light emitting element 4 is straight line shaped in a cross section. Similarly, the oblique surfaces of the oblique portion R1 of the light reflecting member 5 that oppose the other lateral surfaces of the light emitting element 4 are straight line shaped in a cross section. However, the cross-sectional shapes of the oblique surfaces of the oblique portion R1 of the light reflecting member 5 may be suitably formed in accordance with the light extraction direction of the light emitting device. For example, the cross-sectional shape of an oblique surface of the oblique portion R1 may be curved to depress towards the base 35 (e.g., in the direction towards the perimeter of the base 35) or project in the opposite direction to the base 35 (e.g., in the opposite direction to the perimeter of the base). When the cross-sectional shape is curved to depress towards the base 35, the light extraction efficiency can be made higher than in the case of a straight line shape or a curved shape to project in the opposite direction to the base 35.

In the embodiment according to the present invention shown in FIG. 3D, the light reflecting member 5 includes a flat portion R2 that is located on the upper surface 32a of the bottom portion 32 and continuous with the oblique portion R1. The flat portion R2 is the portion in which the height (thickness) from the upper surface 32a of the bottom portion 32 is practically constant. Here, the height (thickness) being practically constant means to include, for example, the case in which there is a height (thickness) variation within manufacturing tolerance in forming the flat portion R2, i.e., the height can vary by about a few tens of microns, for example. The flat portion R2 is disposed to cover the upper surface 32a of the bottom portion 32 and/or the wiring layer 41. The height of the flat portion R2 is preferably equal to or smaller than the height of the lower surface of the light emitting element 4 from the upper surface 32a of the bottom portion 32. The light reflecting member 5 in the flat portion R2 is preferably disposed at a distance from the lateral surfaces 2a of the semiconductor layer 2.

In the light emitting device 100 shown in FIG. 3A, the light reflecting member 5 is disposed on the bottom portion 32 of the base 35 while the upper portions of the inner lateral surfaces 33a of the wall portion 33 is exposed. However, the light reflecting member 5 may be disposed to cover the entire inner lateral surfaces 33a of the wall portion 33 from the upper edges to the lower edges. In the example shown in FIG. 3A, the light extraction efficiency of the light emitting device 100 can be increased as the areas of the inner lateral surfaces 33a of the wall portion 33 covered by the light reflecting member 5 increase. Similarly, in the example shown in FIG. 3C, the light reflecting member 5 may be disposed to entirely cover the inner lateral surfaces 33a of the wall portion 33 from the upper edges to the lower edges. The light reflecting member 5 may be disposed on the upper surface 33c of the wall portion 33 or not. The light reflecting member 5 disposed on the upper surface 33c of the wall portion 33 may cover the upper surface 33c of the wall portion 33 in part or whole in the top view. In the case in which the light reflecting member 5 covers the upper surface 33c of the wall portion 33 in part, the light reflecting member 5 disposed on the upper surface 33c of the wall portion 33 may be disposed in multiple regions that are distanced from one another in the top view. The light reflecting member 5 covering the inner lateral surfaces 33a of the wall portion 33 and the light reflecting member 5 covering the upper surface 33c of the wall portion 33 may be disposed distanced from or continuously with one another.

In the light emitting device 100 according to Embodiment 2, the average aspect ratio of the light reflective particles 11 is calculated, for example, by exposing the cross section passing the center of and is substantially perpendicular to the upper surface 4a of the light emitting element 4 and measuring the thicknesses and the widths of the light reflective particles 11 in the light reflecting member 5 in the cross section. The cross section described as an example here can also be utilized as the cross section to be exposed for calculating the average aspect ratio of the light reflective particles 11 in Embodiment 3 to Embodiment 5.

Here, an ultraviolet light emitting element is occasionally disposed on a base that includes a ceramic base material which is highly resistant to photodegradation because ultraviolet light has a greater energy per photon than visible light to readily cause photodegradation of a resin. In the light emitting device 100 according to Embodiment 2 constructed as above, however, the portion of the surface of the base 35 primarily irradiated by the light emitted from the light emitting element 4 can be covered by the light reflecting member 5. Thus a resin can be used for the base material 30. In general, a resin base material can reduce the manufacturing cost as compared to a ceramic base material.

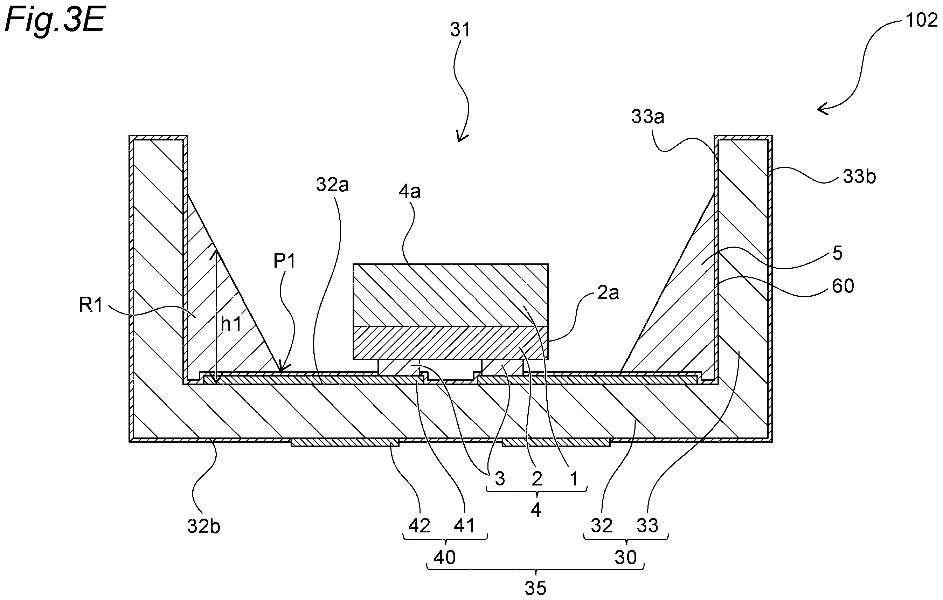

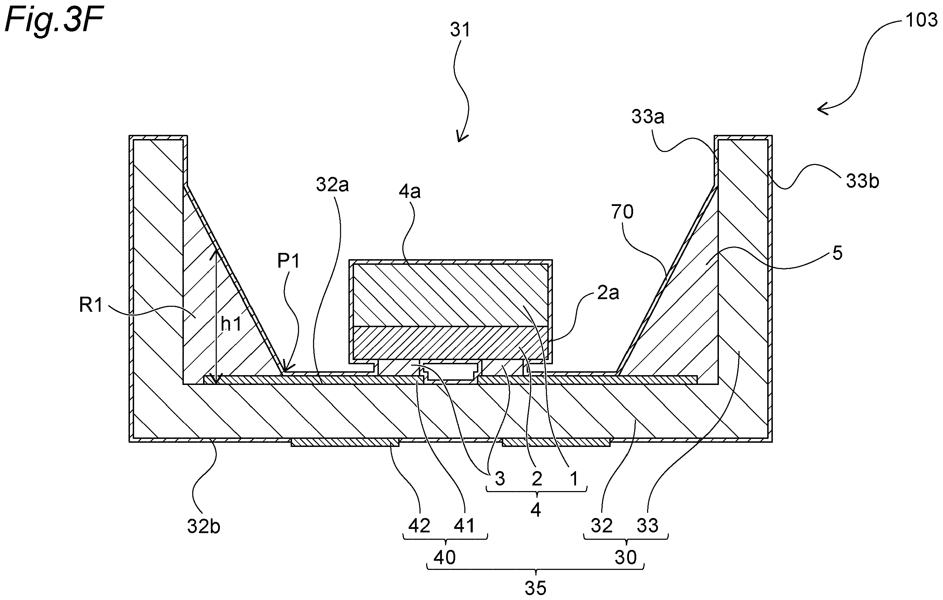

The light emitting device according to Embodiment 2, moreover, may include a first protective film 60 and/or a second protective film 70. The light emitting devices 100 and 101 shown in FIG. 3A to FIG. 3D do not include either a first protective film 60 or a second protective film 70. The light emitting devices 102 and 103 shown in FIG. 3E and FIG. 3F include a first protective film 60 and/or a second protective film 70.

### First Protective Film

A first protective film 60 can be disposed between the base 35 and the light reflecting member 5. The first protective film 60, in an example not forming part of the present invention as shown in FIG. 3E, is disposed on the upper surface 32a of the bottom portion 32 of the base 35. Providing a first protective film 60 can protect the base 35 from external factors, such as dust and humidity. This can improve the reliability of the light emitting device 100.

The protective film 60 can be a single layer film made of a single material or a multilayer film made up of two or more different materials. Examples of materials for the first protective film 60 include inorganic materials, such as alumina, silica, tantalum oxide, niobium oxide, titania, aluminum nitride, silicon nitride, and the like. In the case of employing a multilayer film for the first protective film 60, for example, a film (dielectric multilayer film) stacking a layer made of alumina as a main component and a layer made of silica as a main component, or repeatedly stacking these layers can be used. The thickness of the first protective film 60 is, for example, 3 nm to 250 nm. The thickness of the first protective film 60 is preferably 40 nm to 150 nm. In the case in which the first protective film 60 is a multilayer film, the total thickness of all layers is set to fall within the above ranges.

In order to protect the base 35 from external factors, such as dust and humidity, the first protective film is preferably a denser film than the light reflecting member 5 as described later.

Furthermore, the first protective film 60 can reflect the portion of the light emitted from the light emitting element 4 that passed through the light reflecting member 5. This can increase the light extraction efficiency of the light emitting device 100.

### Second Protective Film

A second protective film 70 can be disposed on the surface of the light reflecting member 5. The second protective film 70 can be further disposed, for example, on the surface of the base 35 exposed from the light reflecting member 5 and the surface of the light emitting element as shown in an example not forming part of the present invention in FIG.3F.

In the case in which the second protective film 70 does not cover the light emitting element 4, the second protective film 70 is, for example, a dielectric multilayer film having light reflectivity. In the case in which the second protective film 70 covers the light emitting element 4, the second protective film 70 is, for example, a dielectric multilayer film having light transmissivity with respect to the light from the light emitting element 4.

The second protective film 70 suppresses the light reflecting member 5, the wiring layer 41, and/or the light emitting element 4 from being damaged by the moisture in the air, corrosive gases, and the like. In other words, providing the second protective film 70 increases the moisture resistance and the gas barrier performance of the light reflecting member 5, the wiring layer 41, and/or the light emitting element 4. Furthermore, allowing the second protective film 70 to continuously cover the surface of the base 35 exposed from the light reflecting member 5 and the surface of the light reflecting member 5 can enhance the adhesion of the light reflecting member 5 to the base 35.

The thickness of and the material for the second protective film 70 can be suitably selected depending on whether the second protective film 70 reflects or transmits light (i.e., whether or not the second protective film 70 covers the light emitting element 4).

In the case in which the second protective film 70 reflects light, the material for the second protective film 70 can be selected from the same material as that for the first protective film 60, and the thickness can be selected from the same thickness range as that for the first protective film 60.

In the case in which the second protective film 70 transmits light, for example, similar to the first protective film 60, a highly light transmissive material is selected from inorganic materials, such as alumina, silica, tantalum oxide, niobium oxide, titania, aluminum nitride, silicon nitride, or the like, and the film thickness is set to increase the light transmissivity. Furthermore, in the case in which the second protective film 70 is a light transmissive dielectric multilayer film, the thickness of each dielectric layer making up the dielectric multilayer film is set to have light transmissivity with respect to the light from the light emitting element 4.

A light emitting device 100 may include either one or both of first protective film 60 and second protective film 70. In the case in which the light emitting device 100 includes only a first protective film 60 (or only a second protective film 70), the first protective film 60 (or the second protective film 70) can be disposed on the outer lateral surfaces 33b of the wall portion 33 and the lower surface 32b of the bottom portion 32 of the base 35. In the case in which the light emitting device 100 includes both first protective film 60 and second protective film 70, a layer made by stacking the first protective film 60 and the second protective film 70 can be disposed on the outer lateral surfaces 33b of the wall portion 33 and the lower surface 32b of the bottom portion 32 of the base 35 and/or the surface of the light emitting element 4.

### MANUFACTURING METHOD 1

An example of a method of manufacturing a light emitting device 100 according to Embodiment 2 (Manufacturing Method 1) will be explained below.

### Providing Base

A base 35 having a bottom portion 32 and a wall portion 33 that define a recess is provided. In the case of employing a resin material for the base material 30 of the base 35, the bottom portion 32 and the wall portion 33 can be integrally formed, for example, by injection molding. In the case of employing a ceramic material for the base material 30 of the base 35, the base can be manufactured by a so-called post firing or co-firing technique. Regardless of a resin material or ceramic material used for the base material 30 of the base 35, the bottom portion 32 and the wall portion 33 may be formed separately and subsequently bonded using an adhesive or the like.

In the description of Manufacturing Method 1 and that of Manufacturing Method 2 discussed later, provision of a member is not limited to manufacturing a member, but includes acquiring of a member through a purchase, transfer, or otherwise.

### Disposing Light Emitting Element

A light emitting element 4 which includes a substrate 1 and a semiconductor layer 2 is disposed on the bottom portion 32 of the base 35 in the recess 31. The light emitting element 4 in any of the examples shown in FIGS. 3A to 3F is mounted by connecting the electrodes 3 to the wiring layer 41 with solder or the like.

### Forming Mixture by Mixing Light Reflective Powder, Silica Powder, and Alkaline Solution

A mixture is provided by combining a powder mix, which is composed of light reflective particles 11 and silica, with an alkaline solution. At this time, a substance that vaporizes during hardening of the mixture such as water (hereinafter also referred to as a vaporizable substance) is preferably added during mixing. The mixture of the powder mix and the alkaline solution (and a vaporizable substance, if added) can be obtained, for example, by mixing them until uniformly viscous and subsequently agitating and deforming under reduced pressure by using agitation deformation apparatus. In forming the mixture, mixing may be performed at room temperature or while heating. If heated, mixing is preferably performed at 90°C at most to suppress the mixture from solidifying. The pH of the resultant mixture is, for example, about 14.

The average particle size of the light reflective particles 11 is 0.6 *µ*m to 43 *µ*m, and the average aspect ratio is 10 or higher, preferably 10 to 70. The light reflective particles 11 comprises, consists essentially of, or consists of, for example, boron nitride or alumina.

The average particle size of silica is, for example, 0.1 *µ*m to 10 *µ*m.

The alkaline solution concentration is, for example, 1 mol/L to 5 mol/L. Setting the alkaline solution concentration too low would deter hardening of the mixture which potentially reduces the strength of or decompose the light reflecting member 5. On the other hand, setting the alkaline solution concentration too high would allow excess alkali metal to precipitate subsequent to hardening the mixture. If the environment allows for condensation, the precipitated metal reacts with condensed moisture, and the products of the reaction can come into contact with and reduce the reliability of the light emitting element 4. The alkaline solution, for example, is a potassium hydroxide solution or sodium hydroxide solution.

Silica and the light reflective particles 11 are mixed at a weight ratio falling within the range of 1:4 to 1:1, for example. In other words, in mixing silica and the light reflective particles 11, the weight of the light reflective particles 11 is, for example, 1 to 4 times the weight of silica.

In the case of providing a mixture without adding any vaporizable substance to the powder mix and the alkaline solution, they are mixed, for example, at a weight ratio of the alkaline solution to the power mixture of 2:10 to 8:10. In other words, in mixing the alkaline solution and the powder mix, the weight of the powder mix is, for example, 1.25 to 5 times the weight of the alkaline solution. Setting the amount of the alkaline solution too small would allow a number of fine lumps to form when mixing the alkaline solution and the powder mix, making forming difficult. On the other hand, if the amount of alkaline solution is too large when mixing the alkaline solution and the powder mix, cracking might occur during hardening, or the strength of the light reflecting member obtained after hardening might be reduced.

In the case of providing a mixture with a vaporizable substance added to the powder mix and the alkaline solution, the alkaline solution and the powder mix are mixed, for example, at a weight ratio of the alkaline solution to the power mixture of 2:10 to 6:10. In other words, in mixing the powder mix and the alkaline solution, the weight of the powder mix is, for example, 1.67 to 5 times the weight of the alkaline solution. The weight ratio of the alkaline solution to the vaporizable substance is, for example, 1:2 to 10:1. In other words, the weight of the vaporizable substance is, for example, 0.1 to 2 times the weight of the alkaline solution.

As described above, in the case of providing a mixture by adding a vaporizable substance, the amount of the alkaline solution can be reduced as compared to the case of not mixing a vaporizable substance. This provides the benefits described below.
(a) In the neutralizing reaction between the alkaline solution and the silica contained in the powder mix, if the alkaline solution is in excess of silica, the alkali components which did not react with silica precipitate. Precipitation of alkali components is not preferable as it reduces the reliability of a light emitting element. For this reason, reducing the amount of the alkaline solution can suppress alkali components from precipitating, and the reliability of the light emitting element from declining.
(b) By adjusting the fluidity (viscosity) of a mixture, an oblique portion R1 whose surface is oblique at a desired angle or curved in a desired shape can be formed from the wall portion 33 towards the light emitting element 4 when disposing the mixture. For this purpose, further adding a vaporizable substance to the powder mix of the powdered light reflective particles 11 and powdered silica, and the alkaline solution when mixing can achieve a desired viscosity for the mixture. Such a mixture can be dispensed to form a desired shape at a desired location in the recess 31.

In the case in which the light reflecting member 5 of a light emitting device 100 contains a scattering material, the scattering material is mixed into the mixture. The average particle size of the scattering material, for example, is smaller than the average particle size of the light reflective particles 11. The scattering material primarily includes, for example, zirconia or titania.

### Disposing Mixture

In the recess 31, the mixture is disposed on the bottom portion 32 of the base 35. The mixture is disposed at a distance from the lateral surfaces 2a of the semiconductor layer 2. The mixture is disposed so as to include a portion in which the height decreases from the wall portion 33 towards the light emitting element 4.

The mixture is disposed, for example, by using a dispenser. In accordance with the present invention, the mixture is simultaneously applied to the bottom portion 32 and the inner lateral surfaces 33a of the wall portion 33. This can form an oblique portion. The oblique portion becomes the oblique portion R1 after the heating step described later. Furthermore, utilizing wetting and spreading of the applied mixture towards the light emitting element 4 can form the portion that practically has a constant height. The portion having a practically constant height becomes the flat portion R2 after the heating step described later. Moreover, simultaneously applying the mixture to the wall portion 33 and the bottom portion 32 or applying the mixture to the inner lateral surfaces 33a of the wall portion 33 can dispose the mixture at a position distanced from the light emitting element 4, thereby suppressing the mixture from covering the lateral surfaces 2a of the semiconductor layer 2.

### Forming Light Reflecting Member by Heating Mixture/Heating Step

A light reflecting member 5 is formed by hardening the mixture by heating. This can be achieved by heating the base 35 on which the mixture and the light emitting element 4 are disposed.

This step may include a preliminary hardening step or not. If a preliminary hardening step is included, the heating step includes a preliminary hardening step which hardens the mixture at a first temperature T1, and a full hardening step which hardens the mixture at a second temperature T2 higher than the first temperature T1. The preliminary hardening step is performed at a first temperature T1, for example, 80°C to 100°C for 10 minutes for 2 hours. The full hardening step is performed at a second temperature T2, for example, 150°C to 250°C for 10 minutes to 3 hours.

Preliminarily hardening the mixture prior to the full hardening step at a lower temperature than that of full hardening can make the resultant light reflecting member 5 less likely to generate a crack.

Furthermore, preliminary hardening and/or full hardening can be performed at atmospheric pressure, or while applying pressure. Hardening the mixture while applying pressure can increase the reflectance of the formed light reflecting member 5 with respect to the light from the light emitting element. This is believed to result because the light reflective particles are more densely populated when the mixture is hardened under pressure. In the case of applying pressure, the pressure applied is, for example, 1 MPa.

By following the steps described above, a light emitting device 100 according to Embodiment 2 can be produced. The step of disposing a light emitting element may be performed before the step of disposing a mixture, or after the step of forming a light reflecting member by heating the mixture. The light emitting device 100 may be manufactured piece by piece, or as an integrally formed block of multiple devices which is subsequently divided into individual devices. Specifically, after providing a substrate block which includes a bottom surface and multiple walls, a light emitting element and a mixture are disposed in the individual recesses formed by the bottom surface and the walls. This is followed by hardening the mixture by heating, and dividing the block into individual light emitting devices.

### Other Steps

### Cleaning Step

Subsequent to the heating step, a cleaning step can be performed to clean the mixture, i.e., the light reflecting member 5. Performing the cleaning step after the heating step can remove residual alkali components which could not react in the neutralizing reaction between the alkaline solution and silica contained in the mixture. This can reduce the decline of the reliability of the light emitting element. For cleaning the light reflecting member 5, water (preferably pure water) may be used. Besides water, alcohols such as IPA, acids such as diluted hydrochloric acid, salts of weak bases such as ammonium chloride, crown ether, cryptand, or a mixture of these may be used. The light reflecting member 5 is cleaned, for example, by dipping the light emitting device 100 equipped with the light reflecting member 5 in water or a mixture of those described above. This can remove any residual alkali components.

### Forming First Protective Film

For the step of forming a first protective film, for example, atomic layer deposition (ALD) can be employed. By employing atomic layer deposition, a dense thin first protective film 60 can be formed on the surface of the base 35 (in the case of FIG. 3A, on the upper surface 32a of the bottom portion 32 of the base 35, the inner lateral surfaces 33a, the upper surface 33c, and the outer lateral surfaces 33b of the wall portion 33 of the base 35, and the lower surface 32b of the bottom portion 32 of the base). Without being limited to atomic layer deposition, the first protective film may be formed by a known technique, such as sputtering, vapor deposition, or the like.

In the case of manufacturing a light emitting device in the order of providing a base, disposing a light emitting element, and disposing a mixture, the step of forming a first protective film is performed, for example, subsequent to providing a base, but before disposing a light emitting element. In this case, a step of exposing a region of the surface of the wiring layer 41 to be connected to the light emitting element 4 is included subsequent to forming the first protective film 60. As a method of exposing the region, for example, the first protective film 60 located on the region can be removed by grinding. As another example, the protective film 60 located on the region can be removed by laser irradiation. As another method, the region can be masked before forming a first protective film 60, followed by removing the mask subsequent to forming the first protective film 60.

The step of forming a first protective film may be performed subsequent to disposing a light emitting element, but before disposing a mixture. In this case, the surface of the light emitting element 4 may also be covered by the first protective film 60.

### Forming Second Protective Film

For the step of forming a second protective film, for example, atomic layer deposition can also be used. In the case of manufacturing a light emitting device in the order of providing a base, disposing a light emitting element, and disposing a mixture, the step of forming a second protective film is performed, for example, subsequent to disposing a mixture.

In FIG. 3F, the second protective film 70 is formed on the surface of the light reflecting member 5, the surface of the light emitting element 4, and the upper surface 32a of the bottom portion 32 of the base 35. Furthermore, the second protective film 70 is formed on the outer lateral surfaces 33b of the wall portion 33 of the base 35 and the lower surface 32b of the bottom portion 32 of the base 35.

With respect to forming a first protective film and forming a second protective film, only one or both of the steps may be performed. In the case of performing both steps, they are performed, for example, in the order of forming a first protective film, disposing a light emitting element, disposing a mixture, and forming a second protective film.

### VARIATIONS OF EMBODIMENT 2

### Base Having Light Reflective Member as Base Material

The base material 30 of the base 35 is not limited to a material different from that for the light reflecting member 5, i.e., it may be made of the same material as that for the light reflecting member 5. This can achieve a higher reflectance than a base material composed of a ceramic, metal, or the like, thereby increasing the light extraction efficiency of the light emitting device. The method of manufacturing this light emitting device according to an example not forming part of the present invention,
(a) providing conductive parts 40,
(b) placing on the conductive parts 40 a mold shaped to integrally form a base material 30 and a light reflecting member 5, pouring a mixture into the mold, and hardening the mixture by heating, and
(c) electrically connecting a light emitting element 4 to the conductive parts 40 that are exposed from the surface of the hardened mixture by grinding, laser irradiation, or the like.

The light emitting devices can be mass produced by using a known method of integrally producing multiple light emitting devices as a block and subsequently dividing the block into individual devices.

### Types of Light Emitting Elements

In the light emitting element 4 disposed in the light emitting device 100, 101, 102, or 103 in FIG. 3A to FIG. 3F, the semiconductor layer 2 is positioned closer to the base 35 than the substrate 1 is, and the light emitting element is flip-chip mounted on the base 35 by electrically connecting the electrodes 3 provided on the lower surface of the semiconductor layer 2 to the conductive parts 40 of the base 35.

The light emitting element of the light emitting devices 100, 101, 102, or 103 may be face-up mounted. In this case, the substrate 1 of the light emitting element is positioned closer to the base 35 than the semiconductor layer 2 is, and the electrodes are disposed on the surface of the semiconductor layer 2 located opposite to the substrate 1. The electrodes of the light emitting element are electrically connected to the conductive parts 40 of the base 35 via wires.

Furthermore, the light emitting element may be of the type that includes a support substrate, a semiconductor layer which successively includes from the support substrate side a p-side semiconductor layer, an emission layer, and an n-side semiconductor layer, a p-side electrode, and an n-side electrode. Such a light emitting element obtained by bonding the support substrate and the semiconductor layer is disposed so as to face the support substrate to the base 35. For the support substrate, for example, a silicon substrate can be used.

Such a light emitting element can be manufactured, for example, by the method described below. First, a semiconductor layer is grown on a growth substrate, and a p-side electrode and an n-side electrode electrically connected to the p-side semiconductor layer and the n-side semiconductor layer, respectively, are arranged. Then a support substrate is bonded on the semiconductor layer via a bonding material, and the growth substrate is removed. Then a portion of the semiconductor layer is removed from the semiconductor layer side until the p-side electrode and the n-side electrode are exposed.

### Protective Device

The light emitting devices 100, 101, 102, and 103 may include a protective device 80 such as that shown in FIG. 3C. The protective device 80 is, for example, a Zener diode. In the case of disposing a protective device 80 on the bottom portion 32 of the base 35, the protective device 80 is preferably covered by the light reflecting member 5 in part or whole. Covering the protective device 80 with the light reflecting member 5 can reduce the decline in the light extraction efficiency attributable to the absorption of light by the protective device 80.

### Lid

The light emitting devices 100, 101, 102, and 103 can further include a lid that covers the recess 31 of the base 35. The lid, for example, is a light transmissive member including a resin or inorganic material. The lid may contain or may not a wavelength conversion material such as a phosphor. In the case of a lid formed of an inorganic base material that contains a phosphor, YAG (yttrium aluminum garnet) for the phosphor, and alumina or silica for the base material, for example, can be used.

The lid is bonded to the base material 30 of the base 35 by using a bonding material, for example, solder (Au-Sn, Au-In, or the like), low melting point glass, or a resin (silicone resin, epoxy resin, or the like). In the case in which the light reflecting member 5 is disposed on the upper surface 33c of the wall portion 33 of the base 35, the light reflecting member 5 disposed on the upper surface 33c can concurrently function as a bonding material that bonds the lid and the base. As such, the light reflecting member 5 can be used as a bonding material in addition to light reflecting purposes. Using the light reflecting member 5 as a bonding material can increase the light extraction efficiency of the light emitting device 100.

The lid may be disposed to achieve a hermetic or non-hermetic construction for the recess 31 of the base 35. In the case in which the lid achieves a hermetic construction for the recess 31, the light emitting element 4, the light reflecting member 5, and the like that are disposed on the bottom portion 32 of the base 35 are less likely to be exposed to the ambient air.

The step of disposing a lid is performed, for example, subsequent to disposing a mixture, and prior or subsequent to forming a light reflecting member (heating step).

### Encapsulating Member

In the recess 31 of the base 35, a encapsulating member can be disposed to encapsulate the light emitting element 4. The encapsulating member is, for example, a resin containing a phosphor. For the phosphor, for example, YAG (yttrium aluminum garnet), and for the base material for the encapsulating member, alumina or silica can be used. The encapsulating member disposed in the recess 31 can encapsulate any member disposed on the bottom portion 32 of the base 35, such as the light reflecting member 5, the first protective film 60, the second protective film 70, the protective device 80, and the like.

When the light-emitting element emits ultraviolet light, as the material of the encapsulating member, it is preferable to use a material having resistance to ultraviolet light, such as fluororesin or low-melting glass. When the light-emitting element emits ultraviolet light, the encapsulating member may or may not contain a phosphor in the material of the encapsulating member described above.

When the light reflecting member has gaps inside, the encapsulating member and/or the protective film can be disposed by impregnating the gap opening on the surface of the light reflecting member 5. This can improve the adhesion between the light reflecting member 5 and the encapsulating member. When the encapsulating member contains a phosphor, the phosphor may also be disposed inside the gap of the light reflecting member.

The encapsulating member may be disposed via the second protective film 70 disposed on the surface of the light reflecting member 5 or may be disposed directly on the surface of the light reflecting member 5

The upper surface of the encapsulating member may be flat or may have unevenness in a cross-sectional view. Alternatively, the upper surface of the encapsulating member may be depressed at the center or may be raised at the center. For example, by forming the upper surface of the encapsulating member into a shape having a lens effect such as a concave lens shape, a convex lens shape, or a Fresnel lens shape, the light from the light emitting element is spread or condensed, thereby increasing the light distribution properties of the light emitting device can be controlled.

### EXAMPLE 1

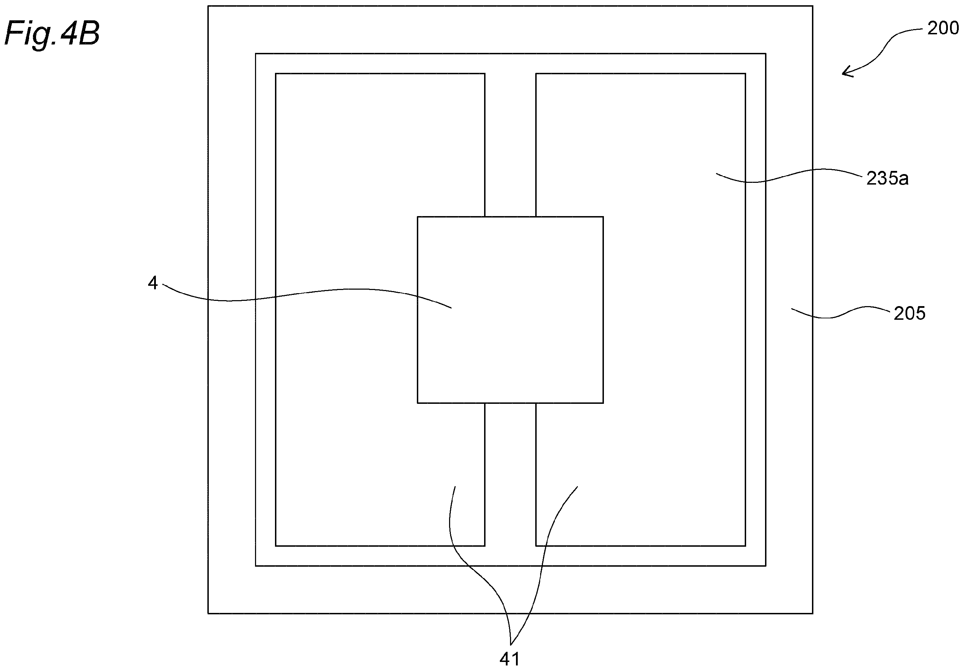

A light emitting device 200 according to Example 1, not forming part of the present invention, as shown in FIG. 4A and FIG. 4B, differs from a light emitting device 100 according to Embodiment 2 such that the base 235 is a plate, and the light reflecting member 205 is a frame member that surrounds the light emitting element 4.

### Light Reflecting Member

The frame-shaped light reflecting member 205 can also be considered as a member that defines, together with the base 235, the recess 231 in which the light emitting element 4 is disposed.

In the light emitting device 200 shown in FIG. 4A, the light reflecting member 205 includes an upper surface, inner lateral surfaces, and outer lateral surfaces. The inner lateral surfaces and the outer lateral surfaces of the light reflecting member 205 are straight line shaped in the cross section, and are perpendicular to the upper surface 235a of the base 235. However, the inner lateral surfaces and/or the outer lateral surfaces of the light reflecting member 205 may be oblique to the upper surface 235a of the base 235. For example, the outer lateral surfaces of the light reflecting member 205 may be perpendicular to the upper surface of the base 235, but the inner lateral surfaces of the light reflecting member 205 may be oblique such that the width of the light reflecting member 205 becomes smaller from the lower edges towards the upper edges of the light reflecting member 205.

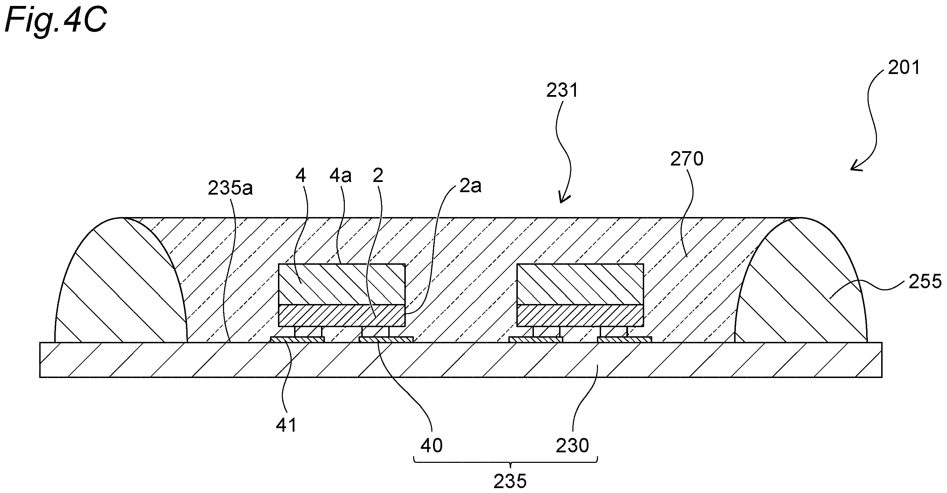

In the light emitting device 201 shown in FIG. 4C, the light reflecting member 255 includes inner lateral surfaces and outer lateral surfaces in which the upper edges of the inner lateral surfaces are in contact with the upper edges of the outer lateral surfaces. The inner lateral surfaces and the outer lateral surfaces of the light reflecting member 255 are curved so as to form a mound on the base 235.

As described above, the inner lateral surfaces and/or the outer lateral surfaces of the light reflecting member may be straight line shaped or curved in a cross section. Without being limited to this, the shapes of the inner lateral surfaces and/or the outer lateral surfaces of the light reflecting member may have a staircase shape in a cross section. The light reflecting member may be such that the upper edges of the inner lateral surfaces and the upper edges of the outer lateral surfaces may be connected via an upper surface or connected directly with one another.

The light emitting device 201, as shown in FIG. 4C, includes a light transmissive member 270 that covers the light emitting elements 4 in the space surrounded by the light reflecting member 255, i.e., the recess 231.

As shown in FIG. 4C, furthermore, a plurality of light emitting elements 4 are disposed in the recess 231. In this case, wavelength conversion members containing different fluorescent materials from one another may be individually disposed on the upper surfaces 4a of the light emitting elements 4. The fluorescent materials contained in the individual wavelength conversion members are selected such that the light emitted from the wavelength conversion members disposed on the light emitting elements 4 individually produce desired colors. For example, the fluorescent materials contained in the individual wavelength conversion members are suitably selected such that white light exits the wavelength conversion member disposed on a certain light emitting element 4, and incandescent light exits the wavelength conversion member disposed on another light emitting element 4. When structured in this manner, a color tunable light emitting device 200, 201 can be produced. The light transmissive member 270 may contain or not contain a fluorescent material. Furthermore, such a color tunable structure is also applicable to light emitting devices 100, 101, 102, 300, and 400 according to Embodiment 2, Embodiment 4, and Embodiment 5.

Alternatively, a light reflecting white encapsulating member (i.e., a resin containing titania or the same material as that for the light reflecting member 255) may be disposed in the recess 231 while exposing the wavelength conversion member disposed on the upper surface 4a of a light emitting element 4.

The shape of the light reflecting member 205, 255 in a top view may be annular, and the outer boundary and/or the inner boundary thereof may have various shapes, such as a quadrangle, circle, octagon, and the like. In the case in which the light reflecting member 205, 255 is polygonal in the top view, the shape may be substantially polygonal with curved corners.

The light emitting device 200, 201 may further include a flat portion, which is made of the same light reflective material as that for the frame member, between the frame-shaped light reflecting member 205, 255 and the light emitting element 4. The flat portion is similar to the flat portion R2 in Embodiment 2 described earlier. The flat portion may be continuous with or distanced from the light reflecting member 205 or 255.

### VARIATIONS OF EXAMPLE 1

Any of the base which is a light reflecting member, the types of light emitting elements, the protective device, the lid, the encapsulating member, and the member disposed on the light emitting element described with reference to the variations of Embodiment 2 is applicable to a light emitting device 200 or 201 according to Example 1.

### MANUFACTURING METHOD 2

A method of manufacturing a light emitting device 200 according to Example 1 (Manufacturing Method 2, not forming part of the present invention) differs from Manufacturing Method 1 in terms of the step of disposing a mixture.

In the step of disposing a mixture in Manufacturing Method 2, for example, a mold having a desired frame shape is placed on the base 235 on which a light emitting element 4 is disposed, followed by disposing a mixture in the mold. The mixture is allowed to flow into the mold through an inlet port of the mold. Subsequently, the base 235 on which the light emitting element 4 and the mixture are disposed is heated with the mold still in place to form a light reflecting member 205 (forming light reflecting member by heating mixture/heating step). After heating step, the mold is removed. A light reflecting member 205 having a desired shape can be produced by utilizing a mold in this manner.

### EXAMPLE 2

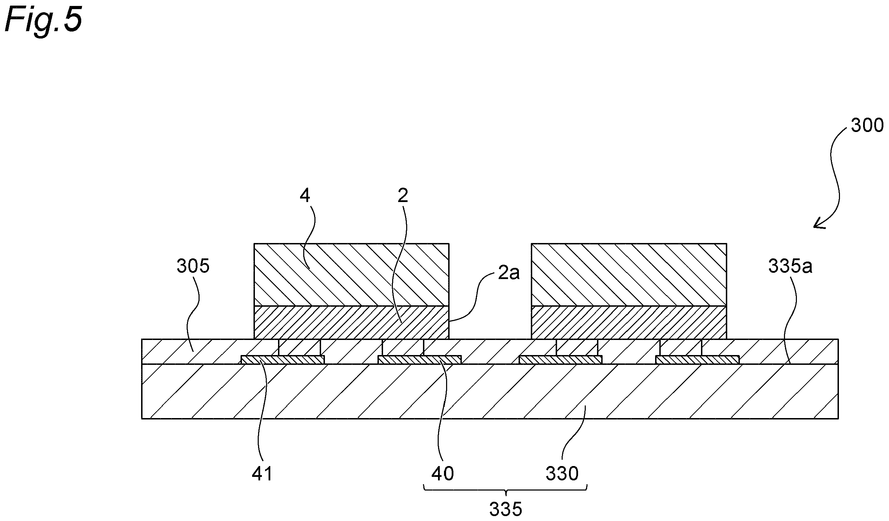

A light emitting device 300 according to Example 2, not forming part of the present invention, as shown in FIG. 5, differs from a light emitting device 100 according to Embodiment 2 in that the base 335 is a plate, and the light reflecting member 305 is disposed to cover the upper surface 335a of the base 335.

### Light Reflecting Member

In the light emitting device 300 shown in FIG. 5, the light reflecting member 305 is disposed to cover the upper surface 335a of the base 335.

The height of the light reflecting member 305 from the upper surface 335a of the base 335 is practically constant with a variation of a few tens of microns at most, for example. The height of the light reflecting member 305 is preferably equal to or smaller than the height of the light emitting elements 4 from the upper surface of the base material 330 of the base 335 to the lower surfaces of the light emitting elements 4. The light reflecting member 305 is preferably disposed at a distance from the lateral surfaces 2a of the semiconductor layer 2 of the light emitting elements 4.

Covering the upper surface 335a of the base 335 with the light reflecting member 305 in this manner can reduce the absorption of the light emitted from the light emitting elements 4 by the base 335.

The light reflecting member 305 is not limited to that disposed to cover the upper surface of the wiring layer 41 as shown in FIG. 5, and may be disposed between the base material 330 and the wiring layer 41. In other words, the light reflecting member 305 may be disposed on the upper surface of the base material 330, and the wiring layer 41 disposed on the upper surface of the light reflecting member.

### VARIATIONS OF EXAMPLE 2

Any of the types of light emitting elements, the protective device, and the member disposed on the light emitting element described with reference to the variations of Embodiment 2 is applicable to a light emitting device 300 according to Example 2.

### EXAMPLE 3

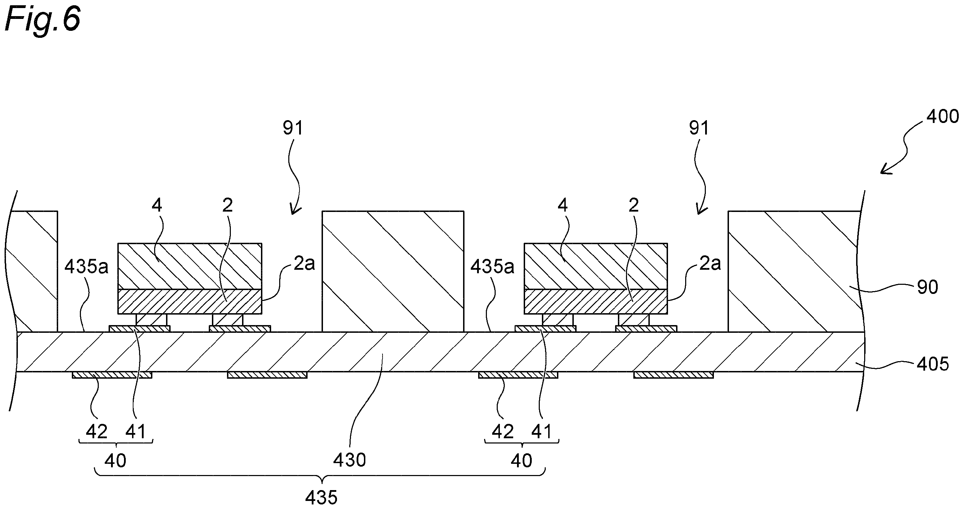

A light emitting device 400 according to Example 3, not forming part of the present invention, as shown in FIG. 6, differs from a light emitting device 100 according to Embodiment 2 in that the base material 430 of the base 435 is a plate that is a light reflecting member 405. The light emitting device 400 according to Embodiment 5 further includes a light guide plate 90 having one or more through holes 91. The through holes 91, for example, are two-dimensionally arranged.

The base 435, which is a light reflecting member 405, is preferably provided to expose the lateral surfaces 2a of the semiconductor layer 2 of the light emitting element 4.

The base 435 which is a light reflecting member 405, together with a light guide plate 90 and a plurality of light emitting elements 4 individually arranged in the through holes 91 of the light guide plate 90, can be utilized as a planar light source.

### VARIATIONS OF EXAMPLE 3

Any of the types of light emitting elements, the protective device, and the member disposed on the light emitting element described with reference to the variations of Embodiment 2 is applicable to a light emitting device 400 according to Example 3. Furthermore, the lid and the encapsulating member described with reference to the variations of Embodiment 2 are applicable to a light emitting device 400 according to Example 3.

### FURTHER EXAMPLES AND REFERENCE EXAMPLES

Examples 1 to 9 and Reference Examples 1 and 2 will be explained.

For each of Reference Examples 1 and 2, and Examples 1 to 9, a light reflecting member was produced and the light reflecting member was measured to obtain the retention rate of contraction subsequent to heating the light reflecting member at 1000°C for one hour. The amount of the alkaline solution added was appropriately adjusted to achieve the viscosity suited for forming.

The light reflecting member 5 of Reference Example 1 was provided as described below.

First, a powder mix was provided by mixing light reflective particles 11 having the average particle size of 1 *µ*m and the average aspect ratio of 4.6 and powdered silica having an average particle size of 0.4 *µ*m in terms of median diameter. The light reflective particles 11 used were boron nitride. Silica and boron nitride were mixed at a weight ratio of 4:5.

A mixture was provided by mixing the powder mix and a 3 mol/L alkaline solution. The alkaline solution used was a potassium hydroxide solution. The alkaline solution and the powder mix were mixed at a weight ratio of 5.8:9.

Subsequently, the mixture was preliminarily hardened by heating at a 90°C first temperature under 1 MPa pressure for one hour.

Then the mixture was fully hardened by heating at a 200°C second temperature under 1 MPa pressure for two hours to produce a light reflecting member 5.

The light reflecting members 5 of the Reference Example 2 and Examples 1 to 9 were provided by a similar method as in Reference Example 1 while changing the materials for the light reflective particles, the average particle size of the light reflective particles, the aspect ratio of the light reflective particles, and the weight ratio of silica to light reflective particles as shown in Table 1.

For each of Reference Examples 1 and 2 and Examples 1 to 9, the light reflecting member 5, which was a disk having a diameter of about 3 cm and a thickness of about 1 mm, was divided into two equal parts, and one of the two parts was heated at 1000°C for one hour. Subsequently, the length percentage of a side of the cross section of the heated light reflecting member part compared to the length of the corresponding side of the cross section of the unheated light reflecting member part was calculated (retention rate of contraction). Table 1 shows the results.

**Table 1**

| | Light Reflective Particles | Average Particle Size (*µ*m) | Average Aspect Ratio | Weight Ratio of Light Reflective Particles to Silica | Retention Rate (%) |
|---|---|---|---|---|---|
| Reference Example 1 | Boron Nitride | 1 | 4.6 | 5:4 | 98.33 |
| Reference Example 2 | Boron Nitride | 2 | 7.7 | 5:4 | 98.41 |
| Example 1 | Boron Nitride | 6 | 17.1 | 1:1 | 99.74 |
| Example 2 | Boron Nitride | 12 | 16.5 | 5:3 | 99.75 |
| Example 3 | Boron Nitride | 30 | 19.2 | 5:3 | 99.82 |
| Example 4 | Boron Nitride | 43 | 18 | 5:3 | 99.61 |
| Example 5 | Alumina | 0.6 | 10 | 2:1 | 99.70 |
| Example 6 | Alumina | 2 | 25 | 2:1 | 99.40 |
| Example 7 | Alumina | 5 | 25 | 2:1 | 99.00 |
| Example 8 | Alumina | 7 | 70 | 2:1 | 99.20 |
| Example 9 | Alumina | 10 | 30 | 2:1 | 99.40 |

The results of Reference Examples 1 and 2 and Examples 1 to 9 show that the retention rates of contraction of Examples 1 to 9 were 99.00% or higher, which were higher than those of Reference Examples 1 and 2. As is made clear from the results, the light reflecting members 5 in Examples 1 to 9 which included silica, an alkali metal, and light reflective particles having an average particle size of 0.6 *µ*m to 43 *µ*m and an aspect ratio of 10 or higher have high heat resistance.

### EXAMPLE 10

Example 10 will be explained next.

In Example 10, a light emitting device according to Embodiment 2 was produced, and the amount of light was evaluated.

The light emitting device of Example 10 was produced as described below.

First, a base 35 which included conductive parts 40 and a base material 30 having a recess 31 was provided. The recess 31 was a rectangular cuboid space having a 2.5 mm × 2.5 mm quadrangular base and a 0.9 mm height. The material used for the bottom portion 32 and the wall portion 33 of the base 35 was AlN. The material used for the conductive parts 40 was Au.

Subsequently, a light emitting element 4 was disposed on the bottom portion 32 of the base 35. The wavelength of the light emitted by the light emitting element 4 was 280 nm. The top view shape of the light emitting element 4 was quadrangular each side being 1 mm.

Subsequently, a powder mix was provided by combining boron nitride having an average particle size of 10 *µ*m and an average aspect ratio of about 20 and silica having an average particle size of 0.3 *µ*m at a weight ratio of 5:3. Subsequently, 2 g of a 3 mol/L potassium hydroxide solution was added to 6 g of the powder mix (the ratio by weight of the alkaline solution to the powder mix is 1:2), 2 g of water was added and mixed using a stirring bar. By subsequently defoaming and agitating the mixture by using a defoaming agitator operable under reduced pressure, a white uniformly viscous mixture was obtained. Furthermore, yttria-stabilized zirconia was added as a scattering material to the resultant mixture.

The mixture produced in the manner described above was disposed in the recess 31 by using a nozzle. The mixture was disposed to form an oblique portion R1 whose height decreased from the wall portion 33 towards the light emitting element 4.

Subsequently, the base 35 on which the light emitting element 4 and the mixture were disposed was heated on a hot plate for preliminary hardening the mixture for 10 minutes at 1 atm pressure. The preliminary hardening was performed at 90°C. Subsequent to preliminary hardening, the mixture was fully hardened in a pressurized nitrogen atmosphere oven at 1 MPa for 40 minutes. The full curing was performed at 200°C.

### COMPARATIVE EXAMPLE 1

The light emitting device of Comparative Example 1 was the same as the light emitting device of Example 10 except for not including a light reflecting member 5.

The amounts of light emitted from the light emitting device 100 of Example 10 and the light emitting device of Comparative Example 1 were compared and evaluated by applying a 100 mA forward current.

### Amount of Light

The amount of light emitted from each of the light emitting devices of Example 10 and Comparative Example 1 was measured by using an integrating sphere. The measurement results show that the amount of light emitted from the light emitting device of Example 10 had a 22.5% increase from that of the light emitting device of Comparative Example 1.

Certain embodiments, variations, examples, and reference examples of the present invention have been described in the foregoing. However, the details of the constituents disclosed are modifiable, i.e., the combinations of elements, the sequences of steps, or the like of the embodiments, variations, examples, and reference examples can be modified without deviating from the scope of the present invention as defined by the claims.

## Claims

1. A light emitting device (100) comprising:
a light emitting element (4), and
a light reflecting member (5) that reflects light emitted from the light emitting element (4),
the light reflecting member (5) comprising plate-shaped light reflective particles (11), silica, and an alkali metal, wherein
an average particle size of the light reflective particles (11) is 0.6 *µ*m to 43 *µ*m, and
an average aspect ratio of the light reflective particles (11) is 10 or higher; the light emitting device (100) further comprising a base (35), wherein
the light emitting element (4) and the light reflecting member (5) are disposed on the base (35),
the light emitting element (4) comprises a semiconductor layer (2), and
a lateral surface (2a) of the semiconductor layer (2) is distanced from the light reflecting member (5) at least in part, wherein further
the base (35) has a bottom portion (32) and a wall portion (33) that define a recess (31),
the light emitting element (4) is disposed in the recess (31), and
the light reflecting member (5) is continuously disposed on an inner lateral surface (33a) of the wall portion (33) and an upper surface (32a) of the bottom portion (32).

2. The light emitting device (100) according to claim 1, further comprising additional light reflecting members (5), wherein
an inner boundary of the wall portion (33) has a quadrangular shape in a top view, and
the light reflecting member (5) and the additional light reflecting members (5) are disposed at four corner portions of the quadrangular shape so as to be distanced from one another.

3. The light emitting device (100) according to claim 1 or 2, wherein
in a top view,
an outer shape of the light emitting element (4) is quadrangular,
an outer shape of the wall portion (33) is quadrangular, and
four sides of the quadrangular outer shape of the light emitting element (4) are not in parallel to any of four sides of the quadrangular outer shape of the wall portion (33).

4. The light emitting device (100) according to any one of claims 1 to 3, further comprising a first protective film (60) disposed between the base (35) and the light reflecting member (5).

5. The light emitting device (100) according to any one of claims 1 to 4, further comprising a second protective film (70) disposed on a surface of the light reflecting member (5).

6. The light emitting device (100) according to any one of claims 1 to 5, wherein
the light reflective particles (11) comprises boron nitride.

7. The light emitting device (100) according to any one of claims 1 to 5, wherein
the light reflective particles (11) comprises alumina, and
an average particle size of the light reflective particles (11) is 0.6 *µ*m to 10 *µ*m.

8. The light emitting device (100) according to any one of claims 1 to 7, wherein the alkali metal is potassium or sodium.

9. The light emitting device (100) according to any one of claims 1 to 8, wherein the light reflecting member (5) contains a scattering material.

10. The light emitting device (100) according to any one of claims 1 to 9, wherein the light emitting element (4) emits ultraviolet light.

11. A method of manufacturing a light emitting device (100), the method comprising:
providing a base (35) having a bottom portion (32) and a wall portion (33) that define a recess (31);
disposing in the recess (31) a light emitting element (4) that comprises a substrate (1) and a semiconductor layer (2);
forming a mixture by mixing powdered silica, powdered plate-shaped light reflective particles (11) having an average particle size in a range of 0.6 *µ*m to 43 *µ*m and an average aspect ratio of 10 or higher, an alkaline solution, and a vaporizable substance;
disposing the mixture in the recess (31) so as to be continuously disposed on an inner lateral surface of the wall portion and an upper surface of the bottom portion as well as distanced from a lateral
surface (2a) of the semiconductor layer (2); and
forming a light reflecting member (5) by heating thereby hardening the mixture.

## Patentansprüche

1. Lichtemittierendes Gerät (100), umfassend:
ein lichtemittierendes Element (4) und
ein lichtreflektierendes Bauteil (5), das von dem lichtemittierenden Element (4) emittiertes Licht reflektiert,
wobei das lichtreflektierende Bauteil (5) plattenförmige lichtreflektierende Partikel (11), Siliziumdioxid und ein Alkalimetall umfasst, wobei
eine durchschnittliche Partikelgröße der lichtreflektierenden Partikel (11) 0,6 µm bis 43 µm ist und
ein durchschnittliches Seitenverhältnis der lichtreflektierenden Partikel (11) 10 oder höher ist;
wobei das lichtemittierende Gerät (100) ferner eine Basis (35) umfasst, wobei
das lichtemittierende Element (4) und das lichtreflektierende Bauteil (5) auf der Basis (35) angeordnet sind,
das lichtemittierende Element (4) eine Halbleiterschicht (2) umfasst und
eine Seitenoberfläche (2a) der Halbleiterschicht (2) zumindest teilweise von dem lichtreflektierenden Bauteil (5) entfernt ist, wobei ferner
die Basis (35) einen Bodenbereich (32) und einen Wandbereich (33) aufweist, die eine Aussparung (31) definieren,
das lichtemittierende Element (4) in der Aussparung (31) angeordnet ist und
das lichtreflektierende Bauteil (5) kontinuierlich auf einer inneren Seitenoberfläche (33a) des Wandbereichs (33) und einer oberen Oberfläche (32a) des Bodenbereichs (32) angeordnet ist.

2. Lichtemittierendes Gerät (100) gemäß Anspruch 1, ferner umfassend zusätzliche lichtreflektierende Bauteile (5), wobei
eine innere Begrenzung des Wandbereichs (33) eine viereckige Form in einer Draufsicht aufweist und
das lichtreflektierende Bauteil (5) und die zusätzlichen lichtreflektierenden Bauteile (5) an vier Eckbereichen der viereckigen Form derart angeordnet sind, dass sie voneinander entfernt sind.

3. Lichtemittierendes Gerät (100) gemäß Anspruch 1 oder 2, wobei
in einer Draufsicht
eine äußere Form des lichtemittierenden Elements (4) viereckig ist,
eine äußere Form des Wandbereichs (33) viereckig ist und
vier Seiten der viereckigen äußeren Form des lichtemittierenden Elements (4) nicht parallel zu einer der vier Seiten der viereckigen äußeren Form des Wandbereichs (33) sind.

4. Lichtemittierendes Gerät (100) gemäß einem der Ansprüche 1 bis 3, ferner umfassend einen ersten Schutzfilm (60), der zwischen der Basis (35) und dem lichtreflektierenden Bauteil (5) angeordnet ist.

5. Lichtemittierendes Gerät (100) gemäß einem der Ansprüche 1 bis 4, ferner umfassend einen zweiten Schutzfilm (70), der auf einer Oberfläche des lichtreflektierenden Bauteils (5) angeordnet ist.

6. Lichtemittierendes Gerät (100) gemäß einem der Ansprüche 1 bis 5, wobei die lichtreflektierenden Partikel (11) Bornitrid umfassen.

7. Lichtemittierendes Gerät (100) gemäß einem der Ansprüche 1 bis 5, wobei
die lichtreflektierenden Partikel (11) Aluminiumoxid umfassen und
eine durchschnittliche Partikelgröße der lichtreflektierenden Partikel (11) 0,6 µm bis 10 µm ist.

8. Lichtemittierendes Gerät (100) gemäß einem der Ansprüche 1 bis 7, wobei das Alkalimetall Kalium oder Natrium ist.

9. Lichtemittierendes Gerät (100) gemäß einem der Ansprüche 1 bis 8, wobei das lichtreflektierende Bauteil (5) ein streuendes Material enthält.

10. Lichtemittierendes Gerät (100) gemäß einem der Ansprüche 1 bis 9, wobei das lichtemittierende Element (4) ultraviolettes Licht emittiert.

11. Verfahren zur Herstellung eines lichtemittierenden Geräts (100), wobei das Verfahren Folgendes umfasst:
Bereitstellen einer Basis (35) mit einem Bodenbereich (32) und einem Wandbereich (33), die eine Aussparung (31) definieren;
Anordnen, in der Aussparung (31), eines lichtemittierenden Elements (4), das ein Substrat (1) und eine Halbleiterschicht (2) umfasst;
Bilden einer Mischung durch Mischen von pulverisiertem Siliziumdioxid, pulverisierten plattenförmigen, lichtreflektierenden Partikeln (11) mit einer durchschnittlichen Partikelgröße in einem Bereich von 0,6 µm bis 43 µm und einem durchschnittlichen Seitenverhältnis von 10 oder höher, einer alkalischen Lösung und einer verdampfbaren Substanz;
Anordnen der Mischung in der Aussparung (31) derart, dass sie kontinuierlich auf einer inneren Seitenoberfläche des Wandbereichs und einer oberen Oberfläche des Bodenbereichs sowie von einer Seitenoberfläche (2a) der Halbleiterschicht (2) entfernt angeordnet ist; und
Bilden eines lichtreflektierenden Bauteils (5) durch Erhitzen, wodurch die Mischung gehärtet wird.

## Revendications

1. Un dispositif électroluminescent (100) comprenant :
un élément électroluminescent (4), et
un élément (5) réfléchissant la lumière qui réfléchit la lumière émise par l'élément électroluminescent (4),
l'élément (5) réfléchissant la lumière comprenant des particules (11) réfléchissant la lumière, en forme de plaque, de la silice et un métal alcalin,
une taille moyenne de particules des particules (11) réfléchissant la lumière allant de 0,6 µm à 43 µm, et
un rapport d'aspect moyen des particules (11) réfléchissant la lumière est de 10 ou plus ;
le dispositif électroluminescent (100) comprenant en outre une base (35),
l'élément électroluminescent (4) et l'élément (5) réfléchissant la lumière étant disposés sur la base (35),
l'élément électroluminescent (4) comprend une couche semi-conductrice (2), et
une surface latérale (2a) de la couche semi-conductrice (2) est au moins en partie éloignée de l'élément (5) réfléchissant la lumière,
la base (35) comportant, en outre, une partie inférieure (32) et une partie paroi (33) qui définissent un évidement (31),
l'élément électroluminescent (4) est disposé dans l'évidement (31), et
l'élément (5) réfléchissant la lumière est disposé de façon continue sur une surface latérale intérieure (33a) de la partie paroi (33) et une surface supérieure (32a) de la partie inférieure (32).

2. Le dispositif électroluminescent (100) selon la revendication 1, comprenant en outre des éléments (5) réfléchissant la lumière supplémentaires,
une limite intérieure de la partie paroi (33) ayant une forme quadrangulaire en vue de dessus, et
l'élément (5) réfléchissant la lumière et les éléments (5) réfléchissant la lumière supplémentaires étant agencés au niveau de quatre parties d'angle de la forme quadrangulaire de manière à être espacés les uns des autres.

3. Le dispositif électroluminescent (100) selon la revendication 1 ou la revendication 2, dans lequel
en vue de dessus,
une forme extérieure de l'élément électroluminescent (4) est quadrangulaire,
une forme extérieure de la partie paroi (33) est quadrangulaire, et
quatre côtés de la forme extérieure quadrangulaire de l'élément électroluminescent (4) ne sont pas parallèles à l'un quelconque des quatre côtés de la forme extérieure quadrangulaire de la partie paroi (33).

4. Le dispositif électroluminescent (100) selon l'une quelconque des revendications 1 à 3, comprenant en outre un premier film protecteur (60) disposé entre la base (35) et l'élément (5) réfléchissant la lumière.

5. Le dispositif électroluminescent (100) selon l'une quelconque des revendications 1 à 4, comprenant en outre un deuxième film protecteur (70) disposé sur une surface de l'élément (5) réfléchissant la lumière.

6. Le dispositif électroluminescent (100) selon l'une quelconque des revendications 1 à 5, dans lequel
les particules (11) réfléchissant la lumière comprennent du nitrure de bore.

7. Le dispositif électroluminescent (100) selon l'une quelconque des revendications 1 à 5, dans lequel
les particules (11) réfléchissant la lumière comprennent de l'alumine, et
une taille moyenne de particules des particules (11) réfléchissant la lumière va de 0,6 µm à 10 µm.

8. Le dispositif électroluminescent (100) selon l'une quelconque des revendications 1 à 7, dans lequel le métal alcalin est le potassium ou le sodium.

9. Le dispositif électroluminescent (100) selon l'une quelconque des revendications 1 à 8, dans lequel l'élément (5) réfléchissant la lumière contient un matériau diffusant.

10. Le dispositif électroluminescent (100) selon l'une quelconque des revendications 1 à 9, dans lequel l'élément électroluminescent (4) émet de la lumière ultraviolette.

11. Un procédé de fabrication d'un dispositif électroluminescent (100), le procédé comprenant :
le fait de prévoir une base (35) ayant une partie inférieure (32) et une partie paroi (33) qui définissent un évidement (31) ;
le fait de disposer dans l'évidement (31) un élément électroluminescent (4) qui comprend un substrat (1) et une couche semi-conductrice (2) ;
le fait de former un mélange en mélangeant de la silice en poudre, des particules (11) réfléchissant la lumière, en forme de plaque, en poudre, ayant une taille moyenne de particules allant de 0,6 µm à 43 µm et un rapport d'aspect moyen de 10 ou plus, une solution alcaline et une substance vaporisable ;
le fait de disposer le mélange dans l'évidement (31) de manière à être disposé de manière homogène sur une surface latérale interne de la partie de paroi et une surface supérieure de la partie inférieure ainsi qu'à distance d'une surface latérale (2a) de la couche semi-conductrice (2) ; et
le fait de former un élément (5) réfléchissant la lumière en chauffant, durcissant ainsi le mélange.
